Europäisches Patentamt

(19) European Patent Office

Office européen des brevets

(11) Publication number: **0 399 307**
**A2**

## (12) EUROPEAN PATENT APPLICATION

(21) Application number: **90108866.6**

(22) Date of filing: **11.05.90**

(51) Int. Cl.⁵: **H03G 3/02, H03G 5/16, H04R 3/04**

(30) Priority: **20.05.89 DE 3916521**

(43) Date of publication of application:
**28.11.90 Bulletin 90/48**

(84) Designated Contracting States:
**AT DE FR GB IT SE**

(71) Applicant: **Blaupunkt-Werke GmbH**
**Robert-Bosch-Strasse 200**
**D-3200 Hildesheim(DE)**

(72) Inventor: **Kässer, Jürgen, Dr.**
**Ahornweg 5**
**D-3201 Diekholzen(DE)**

(74) Representative: **Eilers, Norbert, Dipl.-Phys.**
**Blaupunkt-Werke GmbH**
**Robert-Bosch-Strasse 200**
**D-3200 Hildesheim(DE)**

(54) **Autoradio.**

(57) Es wird ein verbessertes Autoradio für den Betrieb von Lautsprechern über vorgeschaltete Leistungsverstärker beschrieben, bei dem die gehörrichtige Wiedergabe des empfangenen Signals bei unterschiedlichen Leistungsverstärkern gewährleistet wird.

**FIG.1**

EP 0 399 307 A2

**Autoradio**

Die Erfindung ist ein verbessertes Autoradio für den Betrieb von Lautsprechern über Leistungsverstärker.

Es ist allgemein bekannt, daß ein linearer Frequenzgang eines Verstärkers nur dann eine unverzerrte wiedergabe aller Frequenzen in einem Musikstück gewährleistet, wenn die Einstellung so gewählt ist, daß der Lautsprecher die Töne in der Originallautheit wiedergibt.

Bei kleinerer Lautheit treten die tiefen Töne zurück, während sie bei größerer Lautheit hervortreten. Die Ursache liegt in der frequenzabhängigen Lautheitsempfindlichkeit des Ohres.

Bei der Einstellung einer kleineren Lautheit muß man daher die Lautstärke der tiefen Töne hervorheben, um einen Klangeindruck zu erhalten, der mit dem Klangeindruck bei der Wiedergabe mit der Originallautheit übereinstimmt.

Etwas weniger ausgeprägt ist das Bedürfnis der Anhebung der hohen Töne bei geringer Lautheit, weil sich hier der Lautheitsabhängigkeit der Ohrempfindlichkeit die Hörerfahrung überlagert. Leise Töne werden entfernteren Quellen zugeordnet und da die Entfernung die höheren Töne stärker schwächt als die tiefen Töne, empfindet der Gehörsinn die leisen hohen Töne dann lauter als ihrem eigentlichen Schalleindruck entspricht.

Es sind zahlreiche Klangreglerschaltungen bekannt, mit denen die tiefen Frequenzen, gegebenenfalls auch die hohen Töne, automatisch beim Zurückdrehen des Lautstärkereglers angehoben werden. Diese Schaltungen gehen davon aus, daß der Lautstärkeregler einen Endstufenverstärker mit festgelegtem Verstärkungsgrad steuert.

In letzter Zeit wird jedoch reger Gebrauch von der Möglichkeit gemacht, dem eigentlichen Autoradio einen sogenannten Booster, einen besonderen Leistungsverstärker, nachzuschalten, der vom Autobesitzer nach seinem Geschmack aus dem vorhandenen Angebot für den Einbau in sein Auto ausgesucht wird. Wird nun ein solcher Booster der Endstufe des Autoradios nachgeschaltet, dann bewirkt die Auslegung des Klangreglers keine gehörrichtige Wiedergabe mehr.

Der Erfindung lag die Aufgabe zugrunde, diesen Mangel zu beheben.

Die Aufgabe wird durch die im kennzeichnenden Teil des Hauptanspruchs genannte Merkmalskombination gelöst.

Anhand der Zeichnung wird die Erfindung im folgenden näher erläutert.

Es zeigen

Figur 1 ein Blockschaltbild eines Autoradios

Figur 2 ein Blockschaltbild eines Lautstärke-und Klangreglerstellkreises

Das Autoradio empfängt über die Antenne 1 den in dem Tuner 2 eingestellen Sender. In der ZF-Stufe 3 wird die Modulation des empfangenen Senders von dem Träger getrennt und am Ausgang der sich anschließenden NF-Stufe 4 steht diese Modulation zur Speisung des Lautsprechers 5 zur Verfügung.

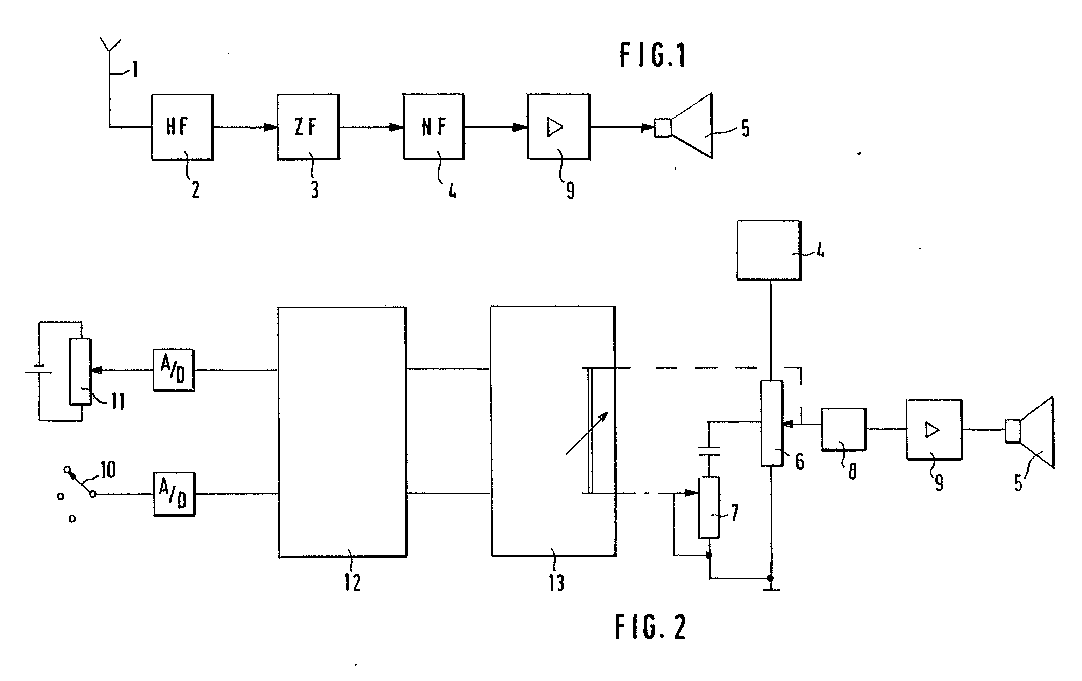

Wie Figur 2 zeigt, ist in der NF-Stufe 4 ein Lautstärkeregler 6 und ein Klangregler 7 wirksam. An den Endstufenverstärker 8 wird im allgemeinen der Lautsprecher 5 direkt angeschlossen. Für diese Betriebsart ist auch der Klangregler ausgelegt.

Wie bereits erwähnt, werden neuerdings zwischen den Endstufenverstärker 8 und den Lautsprecher 5 Booster 9 zwischengeschaltet, die einen linearen Frequenzgang aufweisen. Diese Booster haben je nach Typ einen unterschiedlichen Verstärkungsgrad, d. h. dasselbe Eingangssignal, das dem Ausgangssignal der Endstufe 8 entspricht, wird von ihnen unterschiedlich laut wiedergegeben, stets aber lauter als über die Endstufe allein. Soll die Lautheit des Schalles im Fahrzeug sich nicht ändern, dann muß nach dem Einbau eines Boosters der Lautstärkeregler 6 in der NF-Stufe heruntergedreht werden. Mit der Leiserstellung des Lautstärkereglers werden aber die tiefen Töne durch den Klangregler 7 angehoben. Bei Einstellung des Lautstärkereglers auf die Lautheit der Originallautstärke im mittleren Frequenzbereich würden die tiefen Töne somit überbetont sein.

Zur Vermeidung dieses Nachteils ist in der Schaltung nach Figur 2 ein Sensor 10 für den Verstärkungsgrad des Boosterverstärkers angeschlossen, der z. B. als Wahlschalter ausgebildet sein kann. Außerdem ist ein Lautheitssteller 11 vorgesehen, mit dem sich die Lautheit wählen läßt. Beide Größen, Schalterstellung des Sonsors 10 und Lautheitsstellung 11, werden - gegebenenfalls über AD-Wandler -als Adressen in einen Speicher 12 eingegeben. Der Speicher 12 enthält alle Daten zur gemeinsamen Steuerung des Lautstärkestellers 6 und des Klangreglers 7, die den möglichen Adressen der Schalterstellung des Sensors 10 und des Lautheitsstellers 11 zugeordnet sind.

Das durch die Adresse aufgerufene Datenpaar für die Stellung des Lautstärkereglers und des Klangreglers wird dann in ein Steuerwerk 13 eingegeben, welches deren entsprechende Einstellung bewirkt.

Die Einstellung eines Reglers entsprechend einem vorgegebenen digitalen Wert ist an sich bekannt. Daher erübrigt es sich, auf Einzelheiten des Steuerwerkes 13 noch näher einzugehen. Wesentlich ist nur, daß stets beide Regler in Ab-

hängigkeit voneinander verändert werden.

## Claims

1. Autoradio
mit einem mit dem Lautstärkeregler gekoppelten Klangregler zum Betrieb von Lautsprechern über Leistungsverstärker (Booster) mit frei wählbarem Verstärkungsgrad
gekennzeichnet durch
einen Sensor (10) für den Verstärkungsgrad des gewählten Boosters, einen Einsteller (11) für die Lautheit der gewünschten Schallwiedergabe,
einen Speicher (12), aus dem die der gehörrichtigen Wiedergabe zugeordnete Stellung des Lautstärkereglers (6) und des Klangreglers (7) in Abhängigkeit von dem Verstärkungsgrad des gewählten Leistungsverstärkers (9) und der Einstellung der Lautheit abrufbar sind
und durch ein Steuerwerk (13) zür den Lautstärkeregler (6) und den Klangregler (7), welches bei einer Veränderung des Verstärkungsgrades des Leistungsverstärkers oder der Lautheit des wiederzugebenden Schalles den Lautstärkeregler und den Klangregler in die aus dem Speicher abgerufene Stellung bringt.

FIG.1

FIG.2